**Europäisches Patentamt**

(19) **European Patent Office**

**Office européen des brevets**

(11) Veröffentlichungsnummer: **0 098 834
B1**

(12) **EUROPÄISCHE PATENTSCHRIFT**

(45) Veröffentlichungstag der Patentschrift:
**07.01.87**

(51) Int. Cl.⁴: **H 01 L 29/06**

(21) Anmeldenummer: **82902669.9**

(22) Anmeldetag: **03.09.82**

(86) Internationale Anmeldenummer:
**PCT/DE 82/00175**

(87) Internationale Veröffentlichungsnummer:
**WO 83/02529 (21.07.83** Gazette **83/17)**

(54) **PLANARE HALBLEITERANORDNUNG.**

(30) Priorität: **20.01.82 DE 3201545**

(43) Veröffentlichungstag der Anmeldung:
**25.01.84 Patentblatt 84/4**

(45) Bekanntmachung des Hinweises auf die Patenterteilung:
**07.01.87 Patentblatt 87/2**

(84) Benannte Vertragsstaaten:
**DE FR GB NL**

(56) Entgegenhaltungen:
**WO - A - 82/03949
WO - A - 83/01709
GB - A - 1 348 697
US - A - 3 710 204
US - A - 4 157 563**

(73) Patentinhaber: **ROBERT BOSCH GMBH, Postfach 50,
D-7000 Stuttgart 1 (DE)**

(72) Erfinder: **FLOHRS, Peter, Schickhardtstrasse 69,
D-7411 Reutlingen-Betzingen (DE)**

## Beschreibung

Stand der Technik

Die Erfindung betrifft eine planare Halbleiteranordnung nach der Gattung des Hauptanspruchs. Derartige Halbleiteranordnungen sind bereits bekannt. Sie haben aber den Nachteil, dass bei ihnen von aussen einwirkende elektrische Felder, wie sie beispielsweise durch Polarisation von Abdecklacken beim Betrieb mit hoher Spannung und Temperatur entstehen, zur Degradation von Sperrkennlinien führen können, oder aber, dass die Durchbruchsspannung nur durch Verändern der Dicke der Passivierungsschicht in gewissen Grenzen beeinflussbar, nicht aber nach Aufbringen der Metallisierung variabel ist.

So wird durch die Druckschrift US-P 4 157 563 eine Halbleiteranordnung vorgeschlagen, zur Erhöhung der Sperrfähigkeit eines planaren p-n-Überganges als Passivierungsschicht eine hochohmige Widerstandsschicht, vorzugsweise in Form von miteinander verbundenen konzentrischen Ringen, auf dem Halbleitersubstrat anzubringen. Zur Lösung der gleichen Aufgabe wird in der Druckschrift GB-A 1 348 697 vorgeschlagen, eine Widerstandsschutzschicht auf dem Halbleitersubstrat anzubringen, die vom Elektrodenkontakt überdeckend bis zur Halbleiteranordnung reicht.

Zum nicht vorveröffentlichten Stand der Technik gemäss Artikel 54 (3) EPÜ zählen die beiden Druckschriften PCT-DE 8 200 022 (WO 8 203 949) und PCT-DE 8 200 174 (WO 8 301 709). Sie zeigen jeweils eine planare Transistorstruktur, die von einem Stoppring umgeben ist. Eine Deckelmetallisierung ist von der Transistorstruktur bis über die Stoppringfläche auf dem Halbleitersubstrat angebracht, die gleichzeitig als Kontaktelektrode und elektromagnetische Abschirmung dient.

Vorteile der Erfindung

Die erfindungsgemässe Halbleiteranordnung mit den kennzeichnenden Merkmalen des Hauptanspruchs hat demgegenüber den Vorteil, dass die sich im Betrieb um die erste Zone herum ausbildende Raumladungszone innerhalb der als Stoppring dienenden ringförmigen Zone begrenzt und unterhalb der Deckelektrode von äusseren elektrischen Feldern abgeschirmt wird und dass ferner die Durchbruchsspannung am ersten pn-Übergang in weiten Grenzen veränderbar ist. Anspruch 2 bietet eine besonders einfache Realisierungsmöglichkeit für die Einstellung dieser Durchbruchsspannung mit Hilfe eines Spannungsteilers. Besonders vorteilhafte Weiterbildungen des Gegenstandes nach den Ansprüchen 1 und 2 ergeben sich aus den weiteren Unteransprüchen 3 bis 12.

Zeichnung

Ausführungsbeispiele der erfindungsgemässen Halbleiteranordnung sind in der Zeichnung dargestellt und in der nachfolgenden Beschreibung näher erläutert. Es zeigen:

Fig. 1 einen Schnitt durch eine planare Halbleiteranordnung gemäss der Erfindung mit einem externen ohmschen Spannungsteiler zur Einstellung der Durchbruchsspannung am ersten pn-Übergang,

Fig. 2 die Durchbruchsspannung $U_{Br}$ am ersten pn-Übergang in Abhängigkeit vom Teilerverhältnis dieses externen Spannungsteilers,

Fig. 3 eine Draufsicht auf eine erfindungsgemässe Halbleiteranordnung, bei der der ohmsche Spannungsteiler monolithisch integriert ist,

Fig. 4 einen Schnitt nach der Linie A-A' der Fig. 3,

Fig. 5 eine Draufsicht auf einen Teil einer erfindungsgemässen Halbleiteranordnung, bei der der ohmsche Spannungsteiler teilweise durch eine Kette von Zenerdioden ersetzt ist,

Fig. 6 einen Schnitt nach der Linie B-B' der Fig. 5.

Beschreibung der Ausführungsbeispiele

Ein planarer pn-Übergang 12 soll durch eine Metallelektrode 15 über dem Isolator 13 so geschützt werden, dass das Sperrverhalten durch äussere Einflüsse (z.B. Stoffe mit polaren Gruppen, Alkaliionen, Metallflitter usw.) nicht in unerwünschter Weise beeinflusst werden kann.

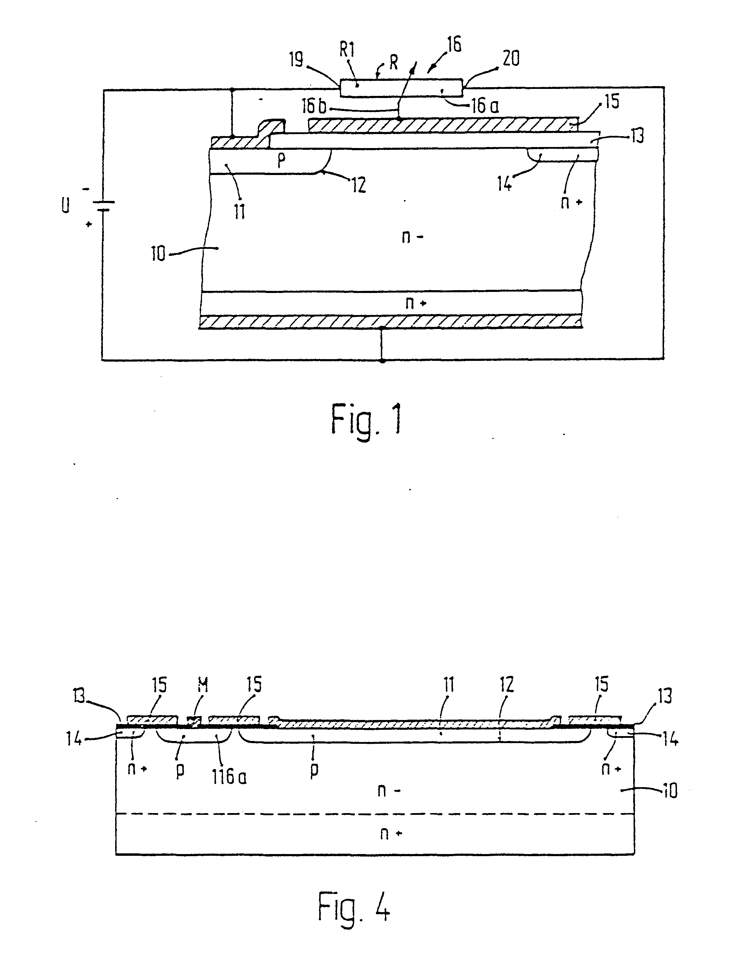

Figur 1 zeigt ein Ausführungsbeispiel in schematischer Darstellung. Das Halbleiterplättchen 10 besteht dabei aus $n^-$-leitendem Silizium, der Isolator 13 aus thermisch gewachsenem Siliziumdioxid. Die Metallelektrode 15 überlappt die p-Zone 11 und ein $n^+$-Gebiet 14, das bei einem npn-Transistor gleichzeitig mit dem Emitter eindiffundiert werden kann. Die $n^+$-leitfähige Emitterzone des npn-Transistors ist jedoch in Fig. 1 nicht dargestellt, so dass die Anordnung der Fig. 1 als Zenerdiode aufzufassen ist. Die erreichbare Durchbruchsspannung hängt ausser von der Grunddotierung des Siliziums wesentlich von der Dicke der Oxidschicht 13 und dem Potential der Elektrode 15 ab.

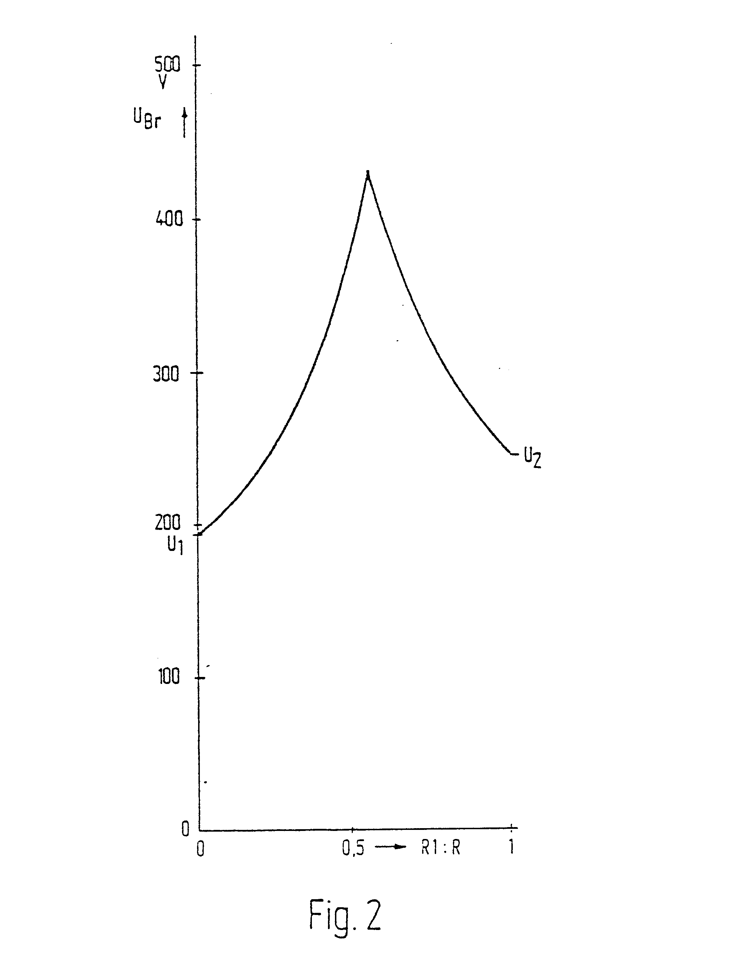

Figur 2 zeigt die Abhängigkeit der Durchbruchsspannung als Funktion des Teilerverhältnisses $R_1 : R$ eines externen Spannungsteilers 16. $U_1$ ist die Durchbruchsspannung, die man erhält, wenn die Deckelektrode 15 direkt an die p-Zone 11 angeschlossen ist. Sie ist im vorliegenden Beispiel deutlich kleiner als diejenige Durchbruchsspannung, die ohne Deckelektrode 15 erzielbar ist. Sie ist gleich der Spannung beim Verarmungsdurchbruch einer entsprechenden MOS-Struktur. $U_2$ ist die Durchbruchsspannung bei Anschluss der Deckelektrode 15 an das $n^+$-Gebiet 14 bzw. die Kollektorzone eines npn-Transistors. Sie ist wegen der durch die Ladungsträgeranreicherung bedingten Feldstärkeerhöhung ebenfalls kleiner als die Durchbruchsspannung ohne Deckelektrode 15. Die grösste erreichbare Durchbruchsspannung beträgt $U_1 + U_2$ bei einem Teilerverhältnis $R_1 : R = U_2 : (U_1 + U_2)$. Der Temperaturgang der Durchbruchsspannung ist bei einem Transistor etwas kleiner als bei einer Zenerdiode mit gleicher Sperrspannung, besonders dann, wenn der Spannungsteiler 16 auf die rechte Flanke der Spannungskurve in Figur 2 eingestellt wird.

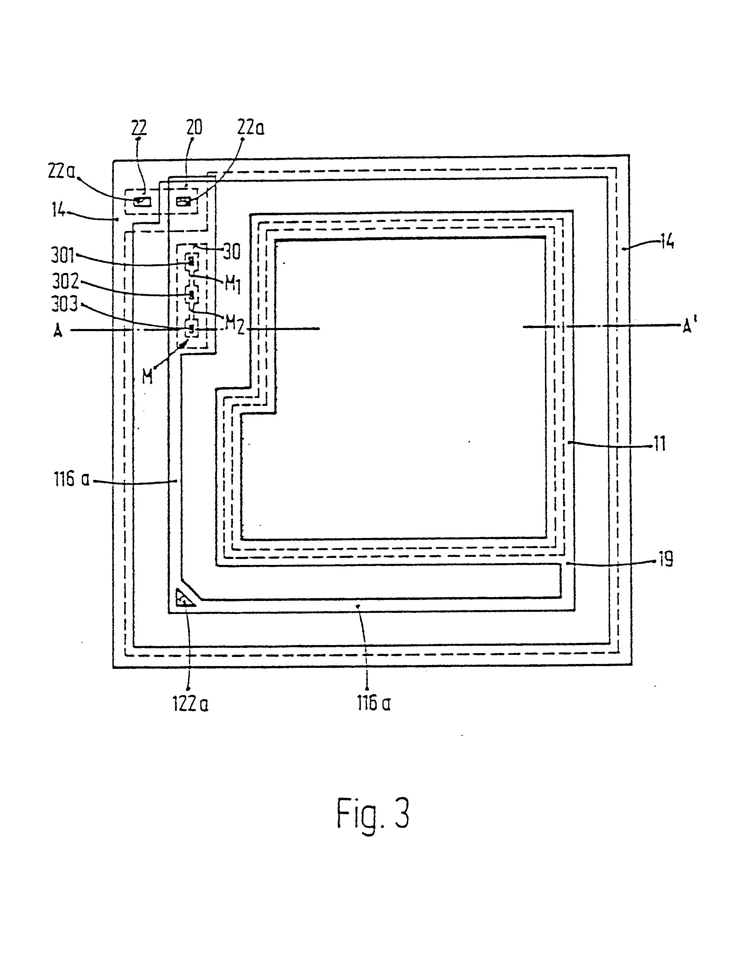

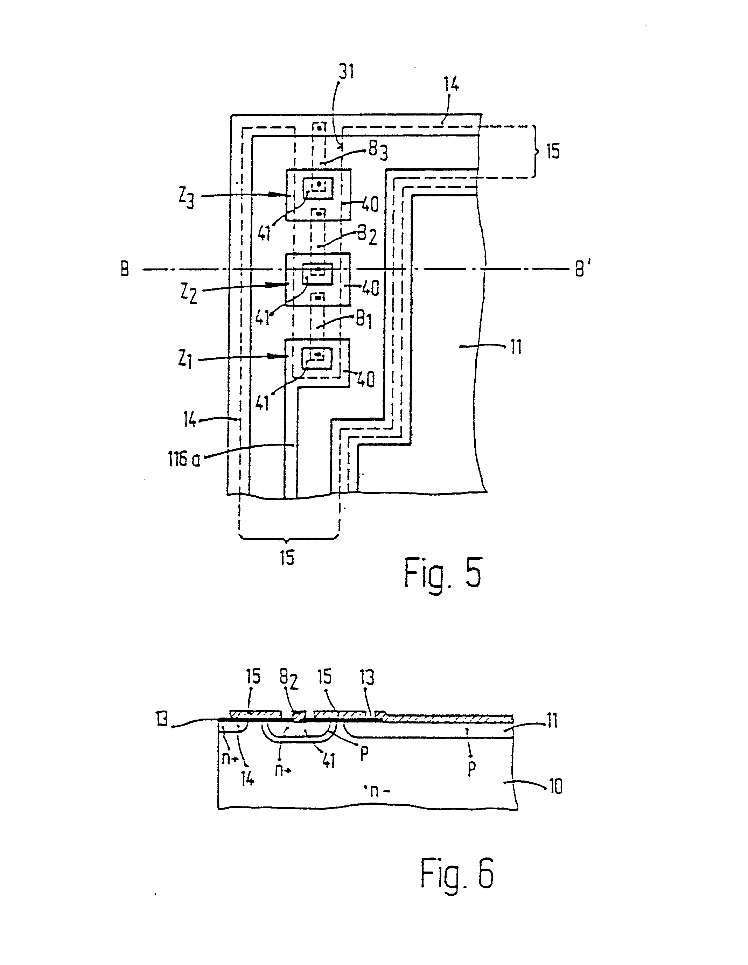

Die Figuren 3 und 4 zeigen ein Beispiel, wie der Spannungsteiler 16 monolithisch integriert werden kann. Wie in Figur 3 in der Draufsicht erkennbar, bildet dabei der Spannungsteilerwiderstand 16a eine von der Hauptoberfläche des Halbleiterplättchens 10 her eindiffundierte langgestreckte p-leitende dritte Zone 116a. Diese dritte Zone 116a besteht aus einem Ausläufer der ersten Zone 11 und ist mindestens teilweise von der Passivierungsschicht 13 und von der darüber hinweg verlaufenden, als Deckelektrode 15 dienenden Metallisierung überdeckt. Der Rand sämtlicher Metallisierungen ist in Fig. 3 mit gestrichelten Linienzügen gekennzeichnet. An einer bestimmten Stelle über der dritten Zone 116a ist die Passivierungsschicht 13 unterhalb der Deckelektrode 15 entfernt. Der innerhalb des so gebildeten Kontaktfensters 122a zu liegen kommende Teil der Deckelektrode 15 bildet dabei den Abgriff 16b des Spannungsteilers 16. Das erste Ende 19 des Spannungsteilerwiderstandes 16a befindet sich in Figur 3 an der rechten unteren Ecke der ersten Zone 11 und stellt einen lückenlosen Übergang der ersten Zone 11 mit der dritten Zone 116a dar. Das zweite Ende 20 des Spannungsteilerwiderstandes 16a wird durch das andere Ende der dritten Zone 116a gebildet, das sich in Figur 3 etwas rechts von der linken oberen Ecke des Halbleiterplättchens 10 befindet. Dieses zweite Ende 20 des durch die dritte Zone 116a gebildeten Spannungsteilerwiderstandes 16a wird durch eine über die Passivierungsschicht 13 hinweggeführte Metallisierung 22 mit einem Teil des Stopprings 14 derart verbunden, dass diese Metallisierung 22 über in der Passivierungsschicht 13 angebrachte Kontaktfenster 22a mit den darunterliegenden, miteinander zu verbindenden Bereichen kontaktiert ist. Über dem linken oberen Teil der dritten Zone 116a ist in der Deckelektrode 15 eine Aussparung 30 angebracht, die die Passivierungsschicht 13 freilegt. In den durch die Aussparung 30 freigelegten Teil der Passivierungsschicht 13 sind Kontaktfenster 301, 302, 303 eingebracht, die sich in Längsrichtung der dritten Zone 116a aneinanderreihen. Diese Kontaktfenster 301, 302, 303 sind durch eine Kurzschlussmetallisierung M überbrückt, die die zwischen diesen Kontaktfenstern 301, 302, 303 liegenden Teile der dritten Zone 116a kurzschliesst. Durch Auftrennen einzelner Teilstücke $M_1$, $M_2$ dieser Kurzschlussmetallisierung M ist der Spannungsteiler 16 abgleichbar, um die Durchbruchsspannung am ersten pn-Übergang 12 auf einen gewünschten Wert einstellen zu können. Ein geeignetes Verfahren zum Auftrennen solcher Metallisierungsbrücken in der DE-AS 2 256 688 beschrieben.

Beim Ausführungsbeispiel nach den Figuren 5 und 6 ist der in der linken oberen Ecke der Figur 3 befindliche Teil des durch die Zone 116a gebildeten ohmschen Spannungsteilerwiderstandes 16a durch eine Kette von Zenerdioden $Z_1$, $Z_2$, $Z_3$ ersetzt. Diese Zenerdioden bestehen jeweils aus einer in die Hauptoberfläche des Halbleiterplättchens 10 eindiffundierten Zone 40 mit p-Leitfähigkeit und aus einer in diese Zone 40 eindiffundierten Zone 41 mit n+-Leitfähigkeit. Im Bereich der Zenerdioden $Z_1$, $Z_2$, $Z_3$ ist in der Metallisierung 15 eine Aussparung 31 vorgesehen, innerhalb die Zenerdioden $Z_1$, $Z_2$, $Z_3$ durch Metallisierungsbrücken $B_1$, $B_2$ miteinander verbunden sind. Innerhalb der Aussparung 31 ist ausserdem die letzte Zenerdiode $Z_3$ der Kette $Z_1$, $Z_2$, $Z_3$ durch eine weitere Metallisierungsbrücke $B_3$ mit einem Teil des Stopprings 14 verbunden. Die Verbindungen sind dabei jeweils so ausgeführt, dass die Metallisierungsbrücken $B_1$, $B_2$, $B_3$ über in der Passivierungsschicht 13 angebrachte Kontaktfenster mit den entsprechenden, darunterliegenden Bereichen kontaktiert sind.

Bei dem in den Figuren 5 und 6 dargestellten Ausführungsbeispiel, bei dem ein Teil des ohmschen Spannungsteilerwiderstandes 16a durch eine Kette von Zenerdioden $Z_1$, $Z_2$, $Z_3$ ersetzt ist, werden die p-leitfähigen Zonen 40 dieser Zenerdioden gleichzeitig mit der p-Zone 11 und der p-Zone 116a eindiffundiert, die n+-Zonen 41 gleichzeitig mit dem die Raumladungszonen des Hauptübergangs 12 begrenzenden n+-Gebiet 14 (bzw. gleichzeitig mit der Emitter-Zone im Falle eines npn-Transistors). Die Durchbruchsspannung der Zenerdioden $Z_1$, $Z_2$, $Z_3$ liegt in der Grössenordnung von 10 Volt.

Zur Einstellung der Sperrspannung des Hauptübergangs 12 können die Zenerdioden $Z_1$, $Z_2$, $Z_3$ einzeln kurzgeschlossen werden, etwa durch kurzzeitiges Anlegen einer hohen Sperrspannung, verbunden mit einem hohen Sperrstrom.

Selbstverständlich ist die Zahl der Abgleichstrecken nicht auf die der Ausführungsbeispiele festgelegt und können die beschriebenen Abgleichverfahren bei Bedarf kombiniert werden.

Wie bereits angedeutet, ist die Erfindung nicht auf die anhand der Zeichnung beschriebenen Ausführungsbeispiele, die jeweils eine Diode betreffen, beschränkt. Vielmehr bezieht sie sich allgemein auf die Beeinflussung des Sperrverhaltens eines einzelnen pn-Übergangs. Es kann sich also hierbei auch um den Basis-Kollektor-Übergang eines Transistors handeln.

**Patentansprüche**

1. Planare Halbleiteranordnung mit einem einkristallinen Halbleiterplättchen (10) eines bestimmten Leitfähigkeitstyps, einer in das Halbleiterplättchen (10) von einer Hauptoberfläche her eindiffundierten ersten Zone (11) vom entgegengesetzten Leitfähigkeitstyp, die mit dem Material des Halbleiterplättchens (10) einen ersten pn-Übergang (12) bildet, mit einer die genannte Hauptoberfläche des Halbleiterplättchens (10) mit Ausnahme von Kontaktfenstern bedeckenden Passivierungsschicht (13), mit einer von der genannten Hauptoberfläche her in das Halbleiterplättchen (10) eindiffundierten zweiten ringförmigen Zone (14), die den gleichen Leifähigkeitstyp wie das Grundmaterial des Halbleiterplättchens (10), aber eine höhere Störstellenkonzentration aufweist, und mit einer auf der Passivierungsschicht (13) zwischen dem Bereich der Schnittstelle des ersten pn-Übergangs (12) mit der Hauptoberfläche des Halbleiterplättchens (10) und dem Bereich oberhalb der ringförmigen Zone (14) aufgebrachten, weiteren ringförmigen Schicht, dadurch gekennzeichnet, dass die zweite ringförmige Zone (14) die Funktion eines Stoppringes aufweist und vollständig von der Passivierungsschicht (13) bedeckt ist, dass die weitere, auf der Passivierungsschicht (13) aufgebrachte Schicht als Deckelektrode (15) dienende Metallisierung ausgebildet ist, die mit keiner der übrigen Elektroden der Halbleiteranordnung kurzgeschlossen ist, und dass das Potential der Deckelektrode (15) auf einen derartigen, über den Bereich der Deckelektrode weitgehend konstanten Wert einstellbar ist, der im Bereich zwischen dem Potentialwert der ersten Zone (11) und dem Potentialwert eines ausserhalb der ersten Zone (11) liegenden Teils des Halbleiterplättchens (10) liegt, wobei dieser Teil einen zur ersten Zone (11) entgegengesetzten Leitfähigkeitstyp aufweist.

Es folgen die ursprünglichen Ansprüche 2 bis 12.

2. Halbleiteranordnung nach Anspruch 1, dadurch gekennzeichnet, dass zur Einstellung des Potentials der Deckelektrode (15) ein Spannungsteiler (16) vorgesehen ist, der einen Spannungsteilerwiderstand (16a) und einen Abgriff (16b) enthält, wobei der Abgriff (16b) an die Deckelektrode (15) angeschlossen ist, das erste Ende (19) des Spannungsteilerwiderstandes (16a) mit der ersten Zone (11) und das zweite Ende (20) des Spannungsteilerwiderstandes (16a) mit einem ausserhalb der ersten Zone (11) liegenden Teil des Halbleiterplättchens (10) verbunden ist, der den zur ersten Zone (11) entgegengesetzten Leitfähigkeitstyp hat.

3. Halbleiteranordnung nach Anspruch 2, dadurch gekennzeichnet, dass der Spannungsteiler (16) monolithisch intergriert ist.

4. Halbleiteranordnung nach Anspruch 3, dadurch gekennzeichnet, dass der Spannungsteilerwiderstand (16a) mindestens teilweise ein ohmscher Widerstand ist.

5. Halbleiteranordnung nach Anspruch 4, dadurch gekennzeichnet, dass der Spannungsteilerwiderstand (16a) eine von der genannten Hauptoberfläche her in das Halbleiterplättchen (10) eindiffundierte langgestreckte dritte Zone (116a) vom gleichen Leitfähigkeitstyp wie die erste Zone (11) enthält, wobei die dritte Zone (116a) einen Ausläufer der ersten Zone (11) bildet und mindestens teilweise von der Passivierungsschicht (13) und von der darüber hinweg verlaufenden, als Deckelektrode (15) dienenden Metallisierung überdeckt wird, und dass an einer bestimmten Stelle über der dritten Zone (116a) die Passivierungsschicht (13) unterhalb der als Deckelektrode (15) dienenden Metallisierung entfernt ist, wobei der innerhalb des so gebildeten Kontaktfensters (122a) zu liegen kommende Teil der Deckelektrode (15) den Abgriff (16b) des Spannungsteilers (16) bildet.

6. Halbleiteranordnung nach Anspruch 5, dadurch gekennzeichnet, dass der Spannungsteiler (16) ein rein ohmscher Spannungsteiler ist und dass die dritte Zone (116a) den gesamten Spannungsteilerwiderstand (16a) bildet.

7. Halbleiteranordnung nach Anspruch 6, dadurch gekennzeichnet, dass das zweite Ende (20) des durch die dritte Zone (116a) gebildeten Spannungsteilerwiderstands (16a) durch eine über die Passivierungsschicht (13) hinweggeführte Metallisierung (22) mit einem Teil des Halbleiterplättchens (10), der einen zur ersten (11) und zur dritten (116a) Zone entgegengesetzten Leitfähigkeitstyp hat, vorzugsweise mit einem Teil des Stopprings (14), derart verbunden ist, dass diese Metallisierung (22) über in der Passivierungsschicht (13) angebrachte Kontaktfenster (22a) mit den darunterliegenden, miteinander zu verbindenden Bereichen (20, 14) kontaktiert ist.

8. Halbleiteranordnung nach einem der Ansprüche 5 bis 7, dadurch gekennzeichnet, dass über einem Teil der dritten Zone (116a) in der als Deckelektrode (15) dienenden Metallisierung eine Aussparung (30) angebracht ist, die die Passivierungsschicht (13) freilegt, dass in den durch die Aussparung (30) freigelegten Teil der Passivierungsschicht (13) Kontaktfenster (301, 302, 303) eingebracht sind, die sich in Längsrichtung der dritten Zone (116a) aneinanderreihen, dass diese Kontaktfenster (301, 302, 303) durch eine Kurzschlussmetallisierung (M) überdeckt sind, die zwischen den Kontaktfenstern (301, 302, 303) liegenden Teile der dritten Zone (116a) kurzschliesst, und dass der Spannungsteiler (16) durch Auftrennen einzelner Teilstücke ($M_1$, $M_2$) dieser Kurzschlussmetallisierung (M) abgleichbar ist, um die Durchbruchsspannung am ersten pn-Übergang (12) auf einen gewünschten Wert einzustellen.

9. Halbleiteranordnung nach Anspruch 4 oder 5, dadurch gekennzeichnet, dass der Spannungsteilerwiderstand (16a) aus einem ohmschen Widerstand und aus einer Kette von zu diesem und zueinander in Reihe geschalteten Zenerdioden ($Z_1$, $Z_2$, $Z_3$) besteht.

10. Halbleiteranordnung nach den Ansprüchen 5 und 9, dadurch gekennzeichnet, dass die Zenerdioden ($Z_1$, $Z_2$, $Z_3$) jeweils aus einer in die genannte Hauptoberfläche des Halbleiterplättchens (10) eindiffundierten Zone (40) vom gleichen Leitfähigkeitstyp wie die erste (11) und die dritte (116a) Zone und aus einer in diese Zone (40) eindiffundierten Zone (41) vom gleichen Leitfähigkeitstyp wie das Grundmaterial des Halbleiterplättchens (10), aber höhere Störstellenkonzentration bestehen, dass im Bereich der Zenerdioden ($Z_1$, $Z_2$, $Z_3$) eine Aussparung (31) in der als Deckelektrode dienenden Metallisierung (15) vorgesehen ist, innerhalb der die Zenerdioden ($Z_1$, $Z_2$, $Z_3$) durch Metallisierungsbrücken ($B_1$, $B_2$) miteinander verbunden sind und innerhalb der die letzte Zenerdiode ($Z_3$) der Kette ($Z_1$, $Z_2$, $Z_3$) durch eine weitere Metallisierungsbrücke ($B_3$) mit einem Teil des Halbleiterplättchens (10), der einen zur ersten (11) und zur dritten (116a) Zone entgegengesetzten Leitfähigkeitstyp hat, vorzugsweise mit einem Teil des Stopprings (14), verbunden ist, wobei diese Metallisierungsbrükken ($B_1$, $B_2$, $B_3$) über in der Passivierungsschicht (13) angebrachte Kontaktfenster mit den entsprechenden, darunterliegenden Bereichen kontaktiert sind.

11. Halbleiteranordnung nach Anspruch 10, dadurch gekennzeichnet, dass der Spannungsteiler (16) durch Kurzschliessen einzelner Zenerdioden ($Z_1$, $Z_2$, $Z_3$) abgleichbar ist, um die Durchbruchsspannung am ersten pn-Übergang (12) auf einen gewünschten Wert einzustellen.

12. Halbleiteranordnung nach Anspruch 11, dadurch gekennzeichnet, dass die Zenerdioden ($Z_1$, $Z_2$, $Z_3$) durch kurzzeitiges Anlegen einer hohen Sperrspannung, verbunden mit einem hohen Sperrstrom, kurzschliessbar sind.

## Claims

1. Planar semiconductor arrangement comprising a monocrystalline semiconductor wafer (10) of a particular type of conductivity, a first zone (11), diffused into the semiconductor wafer (10) from a main surface, of the opposite type of conductivity, which forms a first pn junction (12) with the material of the semiconductor wafer (10), a passivation layer (13) which covers the said main surface of the semiconductor wafer (10) with the exception of contact windows, a second annular zone (14) which is diffused into the semiconductor wafer (10) from the said main surface and which has the same type of conductivity as the base material of the semiconductor wafer (10) but a higher concentration of impurities, and another annular layer which is applied to the passivation layer (13) between the area of the interface of the first pn junction (12) with the main surface of the semiconductor wafer (10) and the area above the annular zone (14), characterized in that the second annular zone (14) has the function of a stop ring and is completely covered by the passivation layer (13), that the further layer, applied to the passivation layer (13) is constructed as a metallization which is used as cover electrode (15) and which is short-circuited to none of the other electrodes of the semiconductor arrangement, and that the potential of the cover electrode (15) is adjustable to such a value, which is largely constant over the area of the cover electrode, which is in the range between the value of the potential of the first zone (11) and the value of the potential of a part of the semiconductor wafer (10) which is located outside the first zone (11), in which arrangement this part has a type of conductivity which is opposite to the first zone (11).

The original Claims 2 to 12 follow.

2. Semiconductor arrangement according to Claim 1, characterized in that for adjusting the potential of the cover electrode (15) a voltage divider (16) is provided which contains a voltage divider resistance (16a) and a tap (16b) in which arrangement the tap (16b) is connected to the cover electrode (15), the first end (19) of the voltage divider resistance (16a) is connected to the first zone (11) and the second end (20) of the voltage divider resistance (16a) is connected to a part of the semiconductor wafer (10) which is located outside the first zone (11) and which has the type of conductivity opposite to the first zone (11).

3. Semiconductor arrangement according to Claim 2, characterized in that the voltage divider (16) is monolithically integrated.

4. Semiconductor arrangement according to Claim 3, characterized in that the voltage divider resistance (16a) is at least partially a resistive impedance.

5. Semiconductor arrangement according to Claim 4, characterized in that the voltage divider resistance (16a) contains an elongated third zone (116a), which is diffused into the semiconductor wafer (10) from the said main surface, of the same type of conductivity as the first zone (11), the third zone (116a) forming an extension of the first zone (11) and being covered at least partially by the passivation layer (13) and by the metallization extending above the latter and serving as cover electrode (15), and that the passivation layer (13) is removed at a particular point above the third zone (116a) below the metallization used as cover electrode (15), the part of the cover electrode (15) coming to be located within the contact window (122a) formed in this manner forming the tap (16b) of the voltage divider (16).

6. Semiconductor arrangement according to Claim 5, characterized in that the voltage divider (16) is a purely resistive voltage divider and that the third zone (116a) forms the entire voltage divider resistance (16a).

7. Semiconductor arrangement according to Claim 6, characterized in that the second end (20) of the voltage divider resistance (16a) formed by the third zone (116a) is connected by a metallization (22), which is carried over the passivation layer (13), to a part of the semiconductor wafer (10) which has a type of conductivity opposite to the first (11) and to the third (116a) zone, preferably to a part of the stop ring (14), in such a manner that this metallization (22) is placed in contact, over the contact windows (22a) applied in the passivation layer (13), with the underlying areas (20, 14) to be connected to each other.

8. Semiconductor arrangement according to one of Claims 5 to 7, characterized in that an opening (30) is applied above a part of the third zone (116a) and the metallization used as cover electrode (15), which opening exposes the passivation layer (13), that contact windows (301, 302, 303), which are lined up in the longitudinal direction of the third zone (116a) are placed into the part of the passivation layer (13), exposed by the opening (30), that these contact windows (301, 302, 303) are bridged by a short-circuit metallization (M) which short-circuits the parts of the third zone (116a) lying between the contact windows (301, 302, 303), and that the voltage divider (16) can be calibrated by separating individual part sections (M₁, M₂) of this short-circuit metallization (M) to adjust the breakdown voltage at the first pn junction (12) to a desired value.

9. Semiconductor arrangement according to Claim 4 or 5, characterized in that the voltage divider resistance (16a) consists of a resistive impedance and of a chain of Zener diodes (Z₁, Z₂, Z₃) which are connected in series with the latter and with each other.

10. Semiconductor arrangement according to Claims 5 and 9, characterized in that the Zener diodes (Z₁, Z₂, Z₃) consist in each case of a zone (40), diffused into the said main surface of the semiconductor wafer (10), of the same type of conductivity as the first (11) and the third (116a) zone and of a zone (41) diffused into this zone (40), of the same type of conductivity as the base material of the semiconductor wafer (10) but with a higher concentration of impurities, that an opening (31), in the metallization (15) used as cover electrode is provided in the area of the Zener diodes (Z₁, Z₂, Z₃), within which opening the Zener diodes (Z₁, Z₂, Z₃) are connected to each other by metallization bridges (B₁, B₂) and within which opening the last Zener diode (Z₃) of the chain (Z₁, Z₂, Z₃) is connected by another metallization bridge (B₃) to a part of the semiconductor wafer (10) which has a type of conductivity opposite to the first (11) and to the third (116a) zone preferably to a part of the stop ring (14), these metallization bridges (B₁, B₂, B₃) being brought into contact with the corresponding underlying areas via contact windows applied in the passivation layer (13).

11. Semiconductor arrangement according to Claim 10, characterized in that the voltage divider (16) can be calibrated by short-circuiting individual Zener diodes (Z₁, Z₂, Z₃) to adjust the breakdown voltage at the first pn junction (12) to a desired value.

12. Semiconductor arrangement according to Claim 11, characterized in that the Zener diodes (Z₁, Z₂, Z₃) can be short-circuited by applying, for a short period, a high blocking voltage associated with a high blocking current.

**Revendications**

1. Dispositif à semi-conducteur planar comportant une plaquette de semi-conducteur monocristallin (10) d'un type déterminé de conduction, comportant dans celui-ci, une première zone (11) de type de conduction opposé, obtenue par diffusion à partir d'une surface principale et formant une première jonction pn (12) avec le matériau de la plaquette de semi-conducteur (10), comportant une couche de passivation (13) qui recouvre la surface principale mentionnée de la plaquette de semi-conducteur (10) à l'exception de fenêtres de contact, comportant une seconde zone annulaire (14) qui est obtenue par diffusion dans la plaquette de semi-conducteur (10) à partir de la surface principale mentionnée et qui présente le même type de conduction que le matériau de base de la plaquette de semi-conducteur (10), mais une concentration plus élevée en impuretés, et comportant une autre couche annulaire rapportée sur la couche de passivation (13) entre la région de l'interface de la première jonction pn (12) avec la surface principale de la plaquette de semi-conducteur (10) et la région située au-dessus de la zone annulaire (14), dispositif caractérisé en ce que la seconde zone annulaire (14) présente la fonction d'un anneau d'arrêt et qu'elle est entièrement recouverte par la couche de passivation (13); en ce que l'autre couche, rapportée sur la couche de passivation (13), est conçue sous forme de métallisation qui sert d'électrode de surface (15) et qui ne peut être mise en court-circuit avec aucune des autres électrodes du dispositif à semi-conducteur ; et en ce que l'on peut régler le potentiel de l'électrode de surface (15) à une valeur qui est largement constante sur toute la région de l'électrode de surface et qui se situe entre la valeur du potentiel de la première zone (11) et la valeur du potentiel d'une partie de la plaquette de semi-conducteur (10) située à l'extérieur de la première zone (11), cette partie présentant un type de conduction opposé à celui de la première zone (11).

2. Dispositif à semi-conducteur selon la revendication 1, caractérisé en ce que pour le réglage du potentiel de l'électrode de surface (15) est prévu un diviseur de tension (16) qui contient une résistance de diviseur de tension (16a) et une prise (16b), étant précisé que la prise (16b) est reliée à l'électrode de surface (15) et que la première extrémité (19) de la résistance du diviseur de tension (16a) est reliée à la première zone (11) et que la seconde extrémité (20) de la résistance du diviseur de tension (16a) est reliée à une partie de la plaquette de semi-conducteur (10) qui est située à l'extérieur de la première zone (11) et qui présente le type de conduction opposé à celui de la première zone (11).

3. Dispositif à semi-conducteur selon la revendication 2, caractérisé en ce que le diviseur de tension (16) est véritablement intégré.

4. Dispositif à semi-conducteur selon la revendication 3, caractérisé en ce que la résistance du diviseur de tension (16a) est au moins partiellement une résistance ohmique.

5. Dispositif à semi-conducteur selon la revendication 4, caractérisé en ce que la résistance du diviseur de tension (16a) contient une troisième zone (116a), du même type de conduction que la première zone (11), s'étendant longitudinalement et obtenue par diffusion dans la plaquette de semi-conducteur (10) à partir de la surface principale mentionnée, étant précisé que la troisième zone (116a) constitue une veine prolongeant la première zone (11) et qu'elle est au moins partiellement recouverte par la couche de passivation (13) et par la métallisation qui court par dessus et sert d'électrode de surface (15); et en ce qu'à un emplacement déterminé au-dessus de la troisième zone (116a) on enlève la couche de passivation (13) située en dessous de la métallisation servant d'électrode de surface (15), étant précisé que la partie de l'électrode de surface (15) qui doit venir à l'intérieur de la fenêtre de contact ainsi obtenue (122a) constitue la prise (16b) du diviseur de tension (16).

6. Dispositif à semi-conducteur selon la revendication 5, caractérisé en ce que le diviseur de tension (16) est un diviseur de tension purement ohmique; et en ce que la troisième zone (116a) constitue l'ensemble de la résistance du diviseur de tension (16a).

7. Dispositif à semi-conducteur selon la revendication 6, caractérisé en ce que la seconde extrémité (20) de la résistance du diviseur de tension (16a) constituée par la troisième zone (116a) est reliée, par l'intermédiaire d'une métallisation (22) qui passe au-dessus de la couche de passivation (13), avec une partie de la plaquette de semi-conducteur (10) qui présente un type de conduction opposé à celui de la première zone (11) et à celui de la troisième zone (116a), de préférence avec une partie de l'anneau d'arrêt (14) de façon telle que cette métallisation (22) soit, par l'intermédiaire de fenêtres de contact (22a) rapportée dans la couche de passivation (13), en contact avec les régions (20, 14) situées par dessous et qu'il faut relier l'une à l'autre.

8. Dispositif à semi-conducteur selon l'une des revendications 5 à 7, caractérisé en ce qu'au-dessus d'une partie de la troisième zone (116a) est rapporté, dans la métallisation servant d'électrode de surface (15), un évidement (30) qui dégage la couche de passivation (13); en ce que dans la partie de la couche de passivation (13) dégagée dans l'évidement (30), sont rapportées des fenêtres de contact (301, 302, 303) qui forment une rangée l'une à côté de l'autre dans la direction longitudinale de la troisième zone (116a); en ce que ces fenêtres de contact (301, 302, 303) sont pontées par une métallisation de mise en court-circuit (M) qui met en court-circuit les parties de la troisième zone (116a) situées entre les fenêtres de contact (301, 302, 303); et en ce que l'on peut équilibrer le diviseur de tension (16) en détachant certains des éléments ($M_1$, $M_2$) de cette métallisation de mise en court-circuit (M), pour régler à une valeur désirée la tension de claquage à la première jonction pn (12).

9. Dispositif à semi-conducteur selon la revendication 4 ou 5, caractérisé en ce que la résistance du diviseur de tension (16a) est constituée d'une résistance ohmique et d'une chaine de diodes Zener ($Z_1$, $Z_2$, $Z_3$) montées en série avec cette résistance et les unes avec les autres.

10. Dispositif à semi-conducteur selon les revendications 5 et 9, caractérisé en ce que les diodes Zener ($Z_1$, $Z_2$, $Z_3$) sont respectivement constituées d'une zone (40), obtenue par diffusion dans la surface principale mentionnée de la plaquette de semi-conducteur (10), du même type de conduction que la première zone (11) et la troisième zone (116a) et d'une zone (41), obtenue par diffusion dans cette zone (40), du même type de conduction que le matériau de base de la plaquette de semi-conducteur (10), mais à concentration d'impuretés plus élevée; en ce que dans la région des diodes Zener ($Z_1$, $Z_2$, $Z_3$) est prévu, dans la métallisation (15) qui sert d'électrode de surface, un évidement (31) à l'intérieur duquel les diodes Zener ($Z_1$, $Z_2$, $Z_3$) sont reliées l'une à l'autre par des ponts de métallisation ($B_1$, $B_2$) et à l'intérieur duquel la dernière diode Zener ($Z_3$) de la chaine ($Z_1$, $Z_2$, $Z_3$) est reliée, par un autre pont de métallisation ($B_3$), à une partie de la plaquette de semi-conducteur (10) qui présente un type de conduction opposé à celui de la première zone (11) et à celui de la troisième zone (116a), de préférence avec une partie de l'anneau d'arrêt (14), étant précisé que ces ponts de métallisation ($B_1$, $B_2$, $B_3$) sont, par l'intermédiaire de fenêtres de contact rapportées dans la couche de passivation (13), en contact avec les régions correspondantes, situées par dessous.

11. Dispositif à semi-conducteur selon la revendication 10, caractérisé en ce que l'on peut équilibrer le diviseur de tension (16) au moyen d'une mise en court-circuit de certaines diodes Zener ($Z_1$, $Z_2$, $Z_3$), pour régler à une valeur désirée la tension de claquage à la première jonction pn (12).

12. Dispositif à semi-conducteur selon la revendication 11, caractérisé en ce que l'on peut mettre les diodes Zener ($Z_1$, $Z_2$, $Z_3$) en court-circuit en amenant brièvement une tension de blocage élevée, liée à une intensité de blocage élevée.

Fig. 1

Fig. 4

Fig. 2

Fig. 3

Fig. 5

Fig. 6